# EUROPÄISCHE PATENTSCHRIFT

(11) **EP 0 592 991 B1**
(45) Veröffentlichungstag und Bekanntmachung des Hinweises auf die Patenterteilung: **02.04.1997**
(21) Anmeldenummer: 93116454.5
(22) Anmeldetag: 11.10.1993
(51) Int. Cl.: H01L 29/423, H01L 29/744

(54) **GTO-Thyristor**
GTO-thyristor
Thyristor GTO

(30) Priorität: 15.10.1992 DE 4234829
(43) Veröffentlichungstag der Anmeldung: 20.04.1994
(73) Patentinhaber: SIEMENS AKTIENGESELLSCHAFT, 80333 München (DE)
(72) Erfinder: Willmeroth, Armin, Dipl.-Phys., D-86163 Augsburg (DE)

(56) Entgegenhaltungen:
- EP-A- 0 066 850
- EP-A- 0 111 166
- EP-A- 0 283 588
- PATENT ABSTRACTS OF JAPAN vol. 10, no. 356 (E-459)29. November 1986 & JP-A-61 154 167 (TOSHIBA CORP) 12. Juli 1986
- PATENT ABSTRACTS OF JAPAN vol. 11, no. 187 (E-516)16. Juni 1987 & JP-A-62 016 570 (HITACHI LTD) 24. Januar 1987
- PATENT ABSTRACTS OF JAPAN vol. 8, no. 53 (E-231)(1490) 9. März 1984 & JP-A-58 206 159 (TOKYO SHIBAURA DENKI K.K) 1. Dezember 1983
- RESEARCH DISCLOSURE Nr. 295 , November 1988 , HAVANT GB Seiten 879 - 880 'GTO Thyristor'
- PATENT ABSTRACTS OF JAPAN vol. 10, no. 356 (E-459)29. November 1986 & JP-A-61 154 167
- PATENT ABSTRACTS OF JAPAN vol. 11, no. 187 (E-516)16. Juni 1987 & JP-A-62 016 570
- PATENT ABSTRACTS OF JAPAN vol. 8, no. 53 (E-231)(1490) 9. März 1984 & JP-A-58 206 159

## Beschreibung

Die Erfindung bezieht sich auf einen GTO-Thyristor mit einem kreisrunden Halbleiterkörper, der katodenseitig eine Vielzahl von streifenförmigen Emitterzonen hat, die in Form mehrerer zueinander konzentrischer Ringe so angeordnet sind, daß ihre Längsachsen radial zum Halbleiterkörper liegen, mit einer an die Emitterzonen angrenzenden katodenseitigen Basiszone, mit einer die Emitterzonen umschließenden Gateelektrode, die elektrisch mit der katodenseitigen Basiszone verbunden ist, und mit einem ringförmigen Gatekontakt, der zwischen zwei der konzentrischen Ringe mit der Gateelektrode verbunden ist.

Ein solcher GTO-Thyristor ist z.B. im europäischen Patent 0 111 166 beschrieben worden. Eines der dort beschriebenen Ausführungsbeispiele zeigt einen GTO-Thyristor, dessen katodenseitige Emitterzonen in Form von fünf zueinander konzentrischen Ringen angeordnet ist. Der ringförmige Gatekontakt liegt von innen gesehen zwischen dem dritten und vierten Ring. Damit sollen die Potentialdifferenzen auf der Innenseite und der Außenseite der Gateelektrode einander ungefähr gleich sein. Ziel dieser Maßnahme ist es, den Abschaltstrom zu erhöhen.

Beim Betrieb von GTO-Thyristoren konzentriert sich häufig der Abschaltstrom auf die inneren Emitterringe. Da hier die zur Verfügung stehende Emitterfläche gemessen an der gesamten Emitterfläche klein ist, wird ein solcher GTO-Thyristor bevorzugt an einem der Innenringe durch Überlastung zerstört.

Der Erfindung liegt die Aufgabe zugrunde, einen GTO-Thyristor der erwähnten Art so auszubilden, daß sich der Strom beim Abschalten auf die außerhalb des ringförmigen Gatekontakts liegenden Emitterringe konzentriert.

Dies wird dadurch erreicht, daß der Spannungsabfall innerhalb der Gateelektrode zwischen dem Außenrand des äußersten Rings und dem Gatekontakt mindestens um 20 % größer ist als der Spannungsabfall innerhalb der Gateelektrode zwischen dem Innenrand des innersten Rings und dem Gatekontakt.

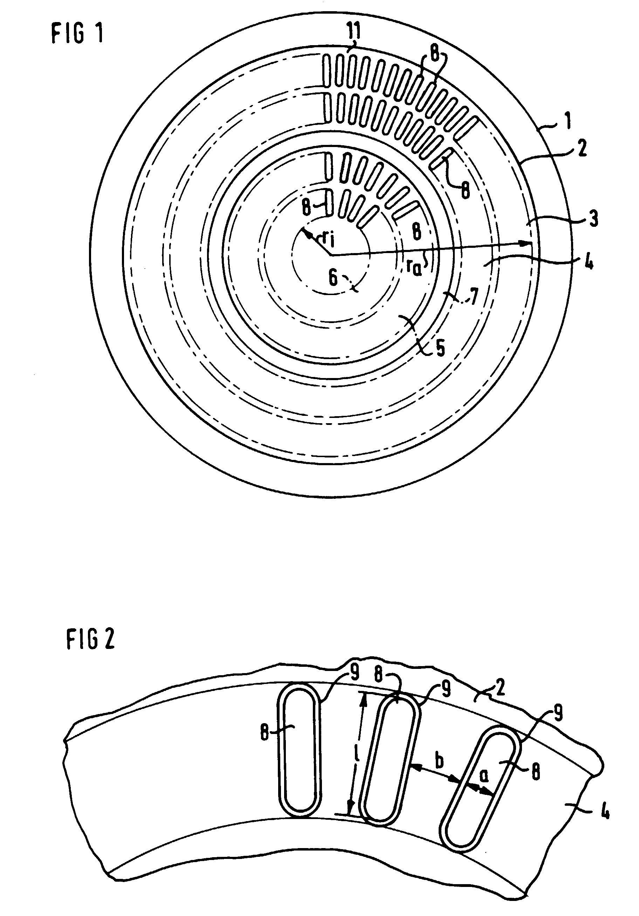

Die Erfindung wird anhand eines Ausführungsbeispiels in Verbindung mit den Figuren 1 und 2 näher erläutert. Es zeigen
- Figur 1: die schematische Aufsicht auf einen GTO-Thyristor und
- Figur 2: die detallierte Aufsicht auf einen Ausschnitt der Anordnung nach Figur 2.

Der GTO-Thyristor nach Figur 1 hat einen kreisrunden Halbleiterkörper 1. Auf diesem sind katodenseitig streifenförmige Emitterzonen 8 angeordnet. Die Längsachsen der streifenförmigen Emitterzonen 8 liegen radial zum Halbleiterkörper 1. Die Emitterzonen 8 sind in Form mehrerer zueinander konzentrischer Ringe auf dem Halbleiterkörper angeordnet. Die konzentrischen Ringe sind von außen nach innen mit 3, 4, 5, 6 bezeichnet. Die katodenseitige Oberfläche des GTO-Thyristors ist mit einer Gateelektrode 2 bedeckt, die die Emitterzonen 8 umschließt, diese jedoch nicht kontaktiert. Einzelheiten sind in Figur 2 gezeigt. Hier ist ein einen Teil des Rings 4 umfassender Ausschnitt nach Figur 1 zu sehen. Die Gateelektrode 2 hat Aussparungen 9, die so bemessen sind, daß die Emitterzonen 8 von der Gateelektrode nicht kontaktiert werden.

Im Ausführungsbeispiel nach Figur 1 ist zwischen den beiden inneren Ringen 5 und 6 und den beiden äußeren Ringen 3 und 4 ein ringförmiger Gatekontakt 7 angeordnet. Dieser ist elektrisch mit der Gateelektrode 2 verbunden.

Die Anordnung der katodenseitigen Emitterzonen 8 und des ringförmigen Gatekontakts 7 sind nun so getroffen, daß das Potential am Außenrand des äußersten Rings 3 (Radius rₐ) bezogen auf die Gateelektrode 7 um mindestens 20 % größer ist als das Potential am Innenrand des innersten Rings 6 (Radius rᵢ), bezogen auf die Gateelektrode 7. Diese Abstimmung läßt sich durch folgende Design-Maßnahmen über den Widerstand beeinflussen:
Anzahl der Ringe innerhalb des Gatekontakts, Anzahl der Ringe außerhalb des Gatekontakts und durch den Durchmesser der Ringe. Eine weitere Einstellmöglichkeit ist durch die Wahl der mittleren Breite b (Figur 2) der Gateelektrode zwischen den einzelnen Aussparungen 9 in der Gateelektrode 2 gegeben. Durch Wahl der Breite b läßt sich derjenige Widerstand signifikant beeinflussen, den der Abschaltstrom des weiter außen liegenden Rings 3 vorfindet.

Das genannte Potentialverhältnis läßt sich aber auch dadurch einstellen, daß die stromtragenden Flächen der streifenförmigen Emitterzonen 8 beiderseits des ringförmigen Gatekontakts 7 aufeinander abgestimmt werden. Da die Breite a der streifenförmigen Emitterzonen 8 aus elektrischen Gründen so klein wie möglich, z. B. einige 100 µm breit gemacht werden muß, läßt sich die Fläche nur durch die Länge der streifenförmigen Emitterzonen einstellen. Im folgenden wird ein konkretes Ausführungsbeispiel für einen GTO-Thyristor genannt, dessen katodenseitige Emitterzonen in Form von acht zueinander konzentrischen Ringen angeordnet sind. Die angegebenen Dimensionierungen beziehen sich von oben nach unten auf den innersten bzw. jeweils weiter außen liegenden Ring.

| Innendurchmesser/mm | Fingerzahl | mittlere Breite b/mm |
|---|---|---|
| 5,05 | 84 | 0,187 |
| 7,9 | 132 | 0,16 |
| 11,1 | 180 | 0,159 |
| 14,65 | 232 | 0,156 |
| 23,65 | 288 | 0,267 |
| 27,2 | 372 | 0,202 |
| 30,75 | 464 | 0,154 |
| 34,3 | 516 | 0,153 |

Die Länge der streifenförmigen Emitterzone beträgt für die beiden inneren Ringe 6 und 5 2,5 bzw. 2,85 mm, für die übrigen Ringe 3,2 mm. Die Breite ist jeweils 0,21 mm. Für diese Anordnung ergab sich ein Spannungsabfall gemessen zwischen dem Außendurchmesser rₐ des äußeren Rings 3 und dem Gatekontakt 7 von 137 mV. Für die inneren Ringe ergibt sich, gemessen zwischen dem Innenradius rᵢ des innersten Ringe 6 und dem Gatekontakt 7 ein Spannungsabfall von 86 mV. Beide Werte wurden bei einem Gatestrom von ca. 700 A gemessen. Der äußere Spannungsabfall ist hier um rund 60 % größer als der innere. Eine Differenz von 20 % dürfte jedoch bereits ausreichend sein, um den gewünschten Erfolg zu erzielen.

Der Vorteil der Erfindung liegt darin, daß sich der Strom beim Abschalten auf die außerhalb des ringförmigen Gatekontakts liegenden Ringe konzentriert. Da hier erheblich mehr Fläche zur Verfügung steht als bei den Ringen innerhalb des Gatekontakts, wird eine Überlastung einzelner Emitter beim Abschalten sicher vermieden.

## Patentansprüche

1. GTO-Thyristor mit einem kreisrunden Halbleiterkörper (1), der katodenseitig eine Vielzahl von streifenförmigen Emitterzonen (8) hat, die in Form mehrerer zueinander konzentrischer Ringe (3, 4, 5, 6) so angeordnet sind, daß ihre Längsachsen radial zum Halbleiterkörper liegen, mit einer an die Emitterzone angrenzenden katodenseitigen Basiszone, mit einer die Emitterzonen umschließenden Gateelektrode (2), die elektrisch mit der katodenseitigen Basiszone verbunden ist, und mit einem ringförmigen Gatekontakt (7), der zwischen zwei der konzentrischen Ringe mit der Gateelektrode (2) verbunden ist,
**dadurch gekennzeichnet,** daß beim Abschalten der Spannungsabfall innerhalb der Gateelektrode (2) zwischen dem Außenrand des äußersten Rings (3) und dem Gatekontakt (7) mindestens um 20 % größer ist als der Spannungsabfall innerhalb der Gateelektrode (2) zwischen dem Innenrand des innersten Rings (6) und dem Gatekontakt (7).

## Claims

1. GTO thyristor having a circular semiconductor body (1) which has, on the cathode side, a multiplicity of strip-shaped emitter zones (8) which are arranged in the form of a plurality of mutually concentric rings (3, 4, 5, 6) in such a way that their longitudinal axes lie radially with respect to the semiconductor body, having a cathode-side base zone which adjoins the emitter zone, having a gate electrode (2) which encloses the emitter zones and is electrically connected to the cathode-side base zone, and having an annular gate contact (7) which is connected to the gate electrode (2) between two of the concentric rings, characterized in that, during turn-off, the voltage drop within the gate electrode (2) between the outer edge of the outermost ring (3) and the gate contact (7) is greater by at least 20% than the voltage drop within the gate electrode (2) between the inner edge of the innermost ring (6) and the gate contact (7).

## Revendications

1. Thyristor GTO avec un corps semi-conducteur circulaire (1), qui possède, côté cathode, un grand nombre de zones émetteur en forme de bandes (8) lesquelles sont disposées suivant des anneaux concentriques entre eux (3, 4, 5, 6) de telle sorte que les axes longitudinaux des bandes ont une position radiale vis-à-vis du corps semi-conducteur, avec une zone de base côté cathode adjacente à la zone émetteur, avec une électrode de gâchette enveloppant les zones émetteur, l'électrode de gâchette étant reliée électriquement à la zone de base côté cathode, et avec un contact de gâchette (7) en forme d'anneau qui est relié à l'électrode de gâchette (2) entre deux des anneaux concentriques,
**caractérisé par**
le fait que, lors de la coupure, la chute de tension à l'intérieur de l'électrode de gâchette (2) entre le bord extérieur de l'anneau le plus à l'extérieur (3) et le contact de gâchette (7) est au moins de 20 % plus importante que la chute de tension à l'intérieur de l'électrode de gâchette entre le bord intérieur de l'anneau le plus à l'intérieur (6) et le contact de gâchette (7).
